# EUROPEAN PATENT APPLICATION

(11) **EP 1 005 156 A1**
(43) Date of publication of application: **31.05.2000**
(21) Application number: 98830711.2
(22) Date of filing: 26.11.1998
(51) Int. Cl.: H03J 9/06, G06K 11/18

(54) **Wireless pointing device for remote cursor control**

(71) Applicant: STMicroelectronics S.r.l., 20041 Agrate Brianza (Milano) (IT)
(72) Inventor: Zambotti, Paolo, 20132 Milano (IT); Zuccaro, Amedeo, 28010 Fosseno di Nebbiuno (IT); Della Torre, Luigi, 20035 Lissone (IT)
(74) Representative: Pellegri, Alberto

(57) **Abstract**

A wireless pointer system to move a cursor on the screen of a video apparatus is composed of a handheld remote control and pointer device comprising a photoelectric sensor sensible to visible radiation and equipped with a focusing and aperture limiting optics, detecting radiation originating from an optically aimed area of said screen; a circuit amplifying the signal generated by said photoelectric sensor, a peak detecting circuit sensing sequences of peaks corresponding to the sequential activation of pixels of said area of the screen at the line scanning frequency of the screen, circuits for signal regeneration and for modulation of a carrier of a transmission channel from said remote control device to a receiver of said apparatus; means in said apparatus demodulating and decoding the received pulses and processing said sequences for determining the coordinates, on said screen, of the aimed area which originates the radiation detected by said photoelectric sensor; means in said apparatus generating a picture of a pointing object or cursor on the screen at the point identified by said coordinates; means in said handheld remote control and pointer device for generating a command code and transmitting of said code to said receiver in said apparatus on said transmission channel for executing a certain function selected by pointing with said cursor to a certain coded area of a selection menu shown on the screen.

## Description

### FIELD OF THE INVENTION

The present invention relates in general to remote control systems through a graphic interface produced on the screen of a monitor or TV set, and more in particular to a system for pointing and selecting coded areas of such a graphic interface.

### BACKGROUND OF THE INVENTION

TV sets, VCRs, satellite video receivers, commonly operated by way of remote controls are appliances of domestic usage.

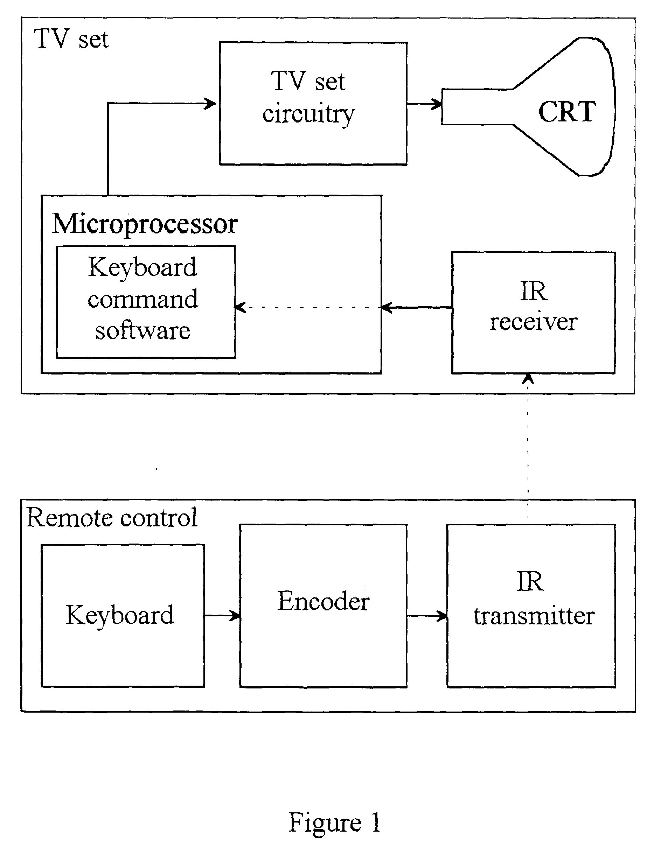

Fig. 1 shows a functional block diagram of a TV set and of its remote control. The remote control sends to the TV set a code that the encoder continued in the remote control associates to the pressing of a certain button. The transmission of the code takes place on a communication channel, commonly realized by an infrared transmitter contained in the remote control and an infrared receiver housed in the TV set.

The signal (code) received by the TV is processed by a microprocessor which, via a software, decodes and activates the function associated to the received code by sending appropriate control signals to the specific TV circuits.

More and more often, TVs are equipped with a software system referred to as "On Screen Display" (OSD) for generating upon an appropriate command, a visualization on the screen of the required function being commanded through the remote control.

In other cases, it may be available a mask to program the various functions that may be recalled on screen by pressing a key on the remote control, onto which control data may be sequentially entered by digitizing them on a keyboard of the remote control.

TV entertainment is rapidly moving toward the diffusion of interactive systems made possible by the advent of digital TV systems and availability of ISDN accesses, wide band channels, etc..

Interactivity implies simplicity and rapidity of intervention by the user, characteristics that only a graphic interface, similar to those normally used in modern PCs, is able to ensure.

Of course, this option entails the use of a pointer device similar to a PC "mouse".

As for the familiar remote control, TV entertainment conditions exclude as unpractical the use of a pointer device connected to the TV set via a wire. Indeed, there are special pointers, namely PC mouses, that do not require a cable connection with the CPU or the monitor but rely on a transmitter in the mouse and a receiver module in the PC or monitor for establishing a communication channel from the mouse to the PC system though dedicated interfaces with a data bus of the PC system.

This type of pointing and selecting devices with transmission systems functioning over short distances, could in principle be used also for interactive TV entertainment but have the serious drawback of requiring an appropriate pad area to move the mouse on while maintaining an appropriate orientation of the mouse towards the TV set.

Other pointer devices for entering data in a PC system in alternative to a mouse, are known. The US Patent No. 4,677,428 describes a wireless optical pen. By resting the tip containing a photoelectric sensor on the outside surface of the CRT screen of the computer's monitor, the passage of the electron beam in correspondence of the contact spot of the tip of the optical pen on the screen may be detected and a luminous pulse may be generated through a LED installed at the other end of the optical pen to be sensed by an IR receiver suitably installed in a position on the frame of the CRT screen, towards which the luminous flash produced by the LED is directed. The optical pen may be used to contour geometric forms, to draw and write on the screen, or even select a menu item visualized on the screen.

Even if capable of substituting in it functions a common pointer connected with a wire, the optical pen described in the above cited patent is unsuitable used like a remote control.

### OBJECT AND SUMMARY OF THE INVENTION

Therefore, the aim of the present invention is to devise a wireless pointer system on the screen of a TV set or monitor, capable of functioning as a common remote control, the remote components of which may be incorporated in a standard remote control with a minimum of additional components.

The device of the invention is based on a surprisingly accurate decoding of the coordinates of the geometric center of a screen area, more or less ample, towards which the user aims an optical system installed in a remote device, by way of sensing a plurality of pulses at a line scanning frequency of the screen coinciding with the sequential activation of pixels (e.g. phosphorous dots) of the aimed area of the screen and by successively recognizing a certain pattern of pulses at a line synchronism frequency repeats itself at the vertical field synchronism frequency.

Inn this way, despite that the area of radiation emission in the visible spectrum sensed by the focusing and aperture limiting optical system of the remote pointer and selector device, may have a nonnegligible size, much greater than the activation area of pixels, for example, by the focused electron beam of a CRT, it is possible, by processing the series of pulses generated by sequential activation of the pixels of the plurality of line segments that define the sensed emission area to derive, the coordinates of the geometric center of the sensed area of the screen. On the other hand, disturbances like the turning on of a lamp, the passage of an opaque body in front of the optics of the focusable sensor of the device, the unsteadiness of the hand, holding the remote device, etc., may be easily filtered out by the system that recognizes them as spurious events.

Essentially, the method of the invention for pointing toward coded areas of a menu mask shown on the screen of a monitor or of a TV set consists in generating the figure of a pointing object (cursor), that may be shifted on the screen by aiming an optical system contained in a remote control device towards a relatively small area of the screen. Peaks of luminous intensity at the line scanning frequency of the screen coinciding with the sequential activation of pixels within the area of the screen aimed to, are sensed by a photoelectric device contained in the remote control. The peaks are eventually regenerated in the form of a sequence or pattern pulses at the line scanning frequency. The requested pulse signal is used to modulate the carrier of a transmission channel from the brandishable remote control device to a receiver installed in the TV set or monitor. In the receiver takes place the demodulation and decoding of the pulse sequences received by the receiver and their processing with the vertical synchronism signal of the monitor or TV set which calculates the coordinates of the geometrical center of the aimed area, originating the radiations detected by the optics of the brandishable device. The calculated coordinates overwrite the previously calculated values in a dedicated register.

The picture of a pointing object or cursor is produced on the screen exactly at the point identified by the coordinates read from said register, the whose values of which are periodically updated at a certain interval that may be a multiple of the period of the field (picture) synchronism signal.

Preferably, the method includes algorithms for effecting a logic filtering of spurious events by testing the repetitiveness of the pattern of pulses at line scanning frequency within a temporal interval which may be a multiple of the period of the vertical synchronism signal (refresh frequency).

This logic filtering eliminates the effects of spurious luminance peaks due for example to the turning on of a lamp in the room, to occasional reflexious, or of opaque bodies crossing the optic line of observation of the brandishable device to unsteadinesses of hand while aiming the device towards the screen, etc..

The pointer system of the invention may be easily realized and may even be advantageously incorporated in a standard remote control with a minimum number of additional components. In this way, the communication channel (for example in the IR spectrum), commonly existing in a common remote control may be exploited also by the aiming system. The electronic circuitry of signal processing implementing the algorithm of the invention may be entirely installed inside the monitor or TV set, or alike source of the graphic interface (menu), without increasing the circuital complexity of the remote control-pointer device.

Essentially, the pointer system of the invention comprises a remote pointer and control device that includes a photoelectric sensor, sensible to visible radiation, equipped with a focusing and aperture limiting optics in order to sense the radiation originating from a screen area of relatively limited size aimed to dimensions; amplifying circuits of the signal generated by the photoelectric sensor peak detecting circuits for detecting peaks coinciding with the sequential activation of the pixels along the line being scanned belonging to the area aimed at of the screen, circuits of logic signal regeneration and of modulation of a carrier of a transmission channel from said remote device to a receiver installed in said monitor or TV set. The receiver includes means to demodulate and decode the sequences of pulses received and processing means to determine the coordinates of the geometrical center of the area originating the radiation sensed by the photoelectric sensor upon the normal scanning by successive horizontal lines of the screen, in function of the temporal position of said pulse sequences in respect to the line scanning period of the screen, means for generating the figure of a pointing object or cursor on the point of the screen identified by said coordinates which are read periodically from an updatable register. Of course, the remote control/aiming device will also be able to generate and transmit to the receiver in the monitor or TV set command code on the same transmission channel for commanding the execution of a certain menu function, pre-selected by bringing the figure of the pointing object over a certain coded area of the menu mask displayed on the screen.

In practice, a simple optical system realized by a lens and an optical diaphragm installed in the brandishable remote device is able to focus on a circular area of a diameter of about 10 to 20 or more millimeters, depending on the distance between the aiming remote device and the screen which ordinarily may range from about 3 to about 6 meters.

The photoelectric sensor of the brandishable remote device, onto which is eventually focused the visible radiation coming from the aimed area on the screen, detects a luminance peak each time the electron beam of a CRT or the scanning bias commands activates the pixels contained in the screen area aimed to by optics of the photoelectric sensor, producing a pattern of 10-20 or more pulses at the line scanning frequency, a pattern which substantially repeats itself at the refresh scanning frequency of the complete picture (e.g. at the frequency of a CRT vertical synchronism signal).

According to a preferred embodiment of the invention, the aiming device is incorporated into a common remote control and the combined remote control-pointer device is equipped with an electronic circuitry capable to coordinate and supervise the access to the transmitter on the transmission channel towards the TV set or monitor by the standard remote control keyboard and by the photoelectric sensor of the aiming system of the invention.

As long as no key of the remote control keyboard is pressed, the transmission channel is left at the disposal of the photoelectric sensor sensible to visible light. When a key is pressed, the access to the channel is automatically attributed to the keyboard for the time necessary for the transmission of the particular code and then returns at the disposal of the photoelectric sensor for a minimum uninterruptable time, after which, if a key is pressed again, the access to the transmission channel returns to the keyboard.

Therefore, if a key of the remote control is kept pressed for a sufficiently long time, an alternate transmission occurs: for a certain period of time, the code associated to the key of the keyboard is transmitted and during the successive period of time is again the signal generated by the photoelectric sensor in the visible field to be transmittable on the transmission channel to the receiver in the TV set or monitor.

Of course, during the time necessary for the command code transmission the cursor that is eventually displayed on the screen is maintained in an unchanged position.

In the TV set or in the monitor, from the signal received (typically a modulated IR signal) the useful information for the pointer function is separated from the information related to the command codes produced by pressing the control keys of the keyboard of the remote control. The separation of the two types of data contained in the received and demodulated signal may be even more simplified by employing a different carrier frequency.

Of course, the two signals are obtained by demodulating the respective carrier. Carrier demodulation, at least for the pointer signal and preferably for both types of signals, is carried out in a digital mode.

Once the separation is completed, the code signals originated from the remote control keyboard are sent directly to the microprocessor while the signals pertaining to the pointer system of the invention, before being sent to the microprocessor, are processed together with the picture synchronism signal derived from the TV circuitry.

According to an embodiment, the pulses originating from the receiver reset a timer after storing its content in a register. The register content is then compared with minimum and maximum values and, depending on the result of the comparison, the comparator sends a count increment signal or a reset signal to the counter. After receiving a certain number of count increment signals from the comparator, its content to a logic circuitry that mixes the content of the counter with the vertical synchronism signal and feeds the result to the microprocessor.

The information carried by the logic signal is contained in the switching fronts of the signals and more precisely in their relative temporal separation.

The invention is defined in the annexed claim 1 and particularly effective embodiments are defined in the remaining claims.

### BRIEF DESCRIPTION OF THE DRAWINGS

The various aspects and advantages of the system of the invention will become even clearer through the following description of an embodiment of the invention and by referring to the annexed drawings, wherein:
**Figure 1** is a functional scheme of a common TV set controlled from a distance by a remote control;
**Figure 2** shows the scheme of a TV set controlled by a remote control incorporating the pointer system of the invention;
**Figure 3** is the circuit diagram of a combined remote control-pointer of the invention;
**Figure 4** is a scheme of the optical system for focusing and limiting the aperture, installed in the remote pointer device;
**Figure 5** is a block diagram of the processing hardware installed in the TV or monitor;
**Figure 6** is a flow chart of the algorithm of calculation of the coordinates of the geometrical center of the area pointed by the optics of the remote pointer device.

### DESCRIPTION OF AN EMBODIMENT OF THE INVENTION

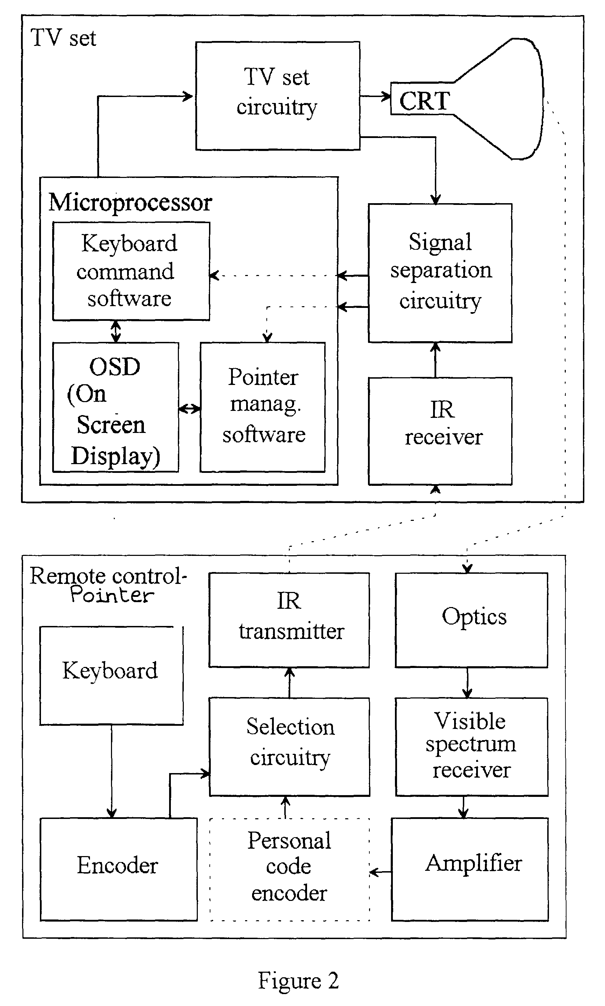

By referring to Fig. 2, and by comparing it with the diagram of a common TV controlled by the remote control of Fig. 1, it may be immediately recognized the hardware and the software common to both diagrams. The hardware and the software for operating the keys of the remote control may be assumed as remaining perfectly identical.

The incorporation within a normal remote control of the remote pointer functionalities according to the present invention implies the installation in the remote device (combined remote control and pointer) of a rather simple optical system for focusing and limiting the aperture, which may be constituted by a convergent lens and by diaphragm placed in correspondence to the focusing point of the lens. In this way, the luminous rays (limitedly those parallel to the optical axis) that are permitted to pass though the optical system illuminate a photoelectric sensor, typically a photodiode.

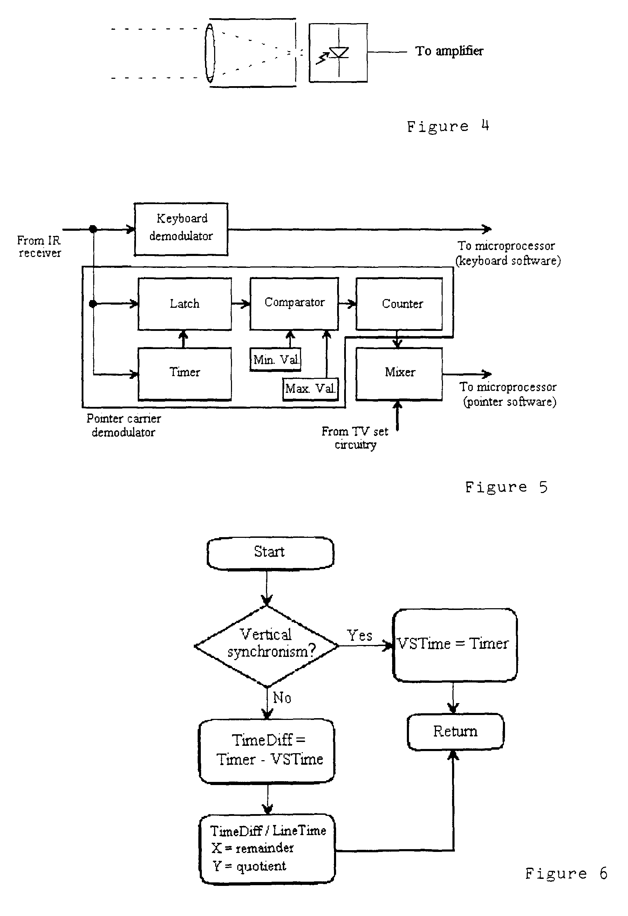

The scheme of the optical system and of the photoelectric sensor is illustrated in Fig. 4.

The signal produced by the photoelectric sensor is amplified by the amplifier block that includes a peak detector and by an output stage that regenerate a digital signal in the form of sequences of pulses corresponding to luminance peaks of the radiation sensed through the optical system and the photodiode aimed toward a spot on the screen.

The optics and the detector sense the light originating from a relatively small area (of about 10-20 mm of diameter) on the screen. Therefore, the amplifier block will output a certain sequence of pulses at a frequency equivalent to the line scanning frequency of the screen (e.g. horizontal synchronism), the duration of which depends on the size of the detected emitting area of the screen, a multipulse pattern that repeats itself at the picture scanning frequency ( e.g. vertical synchronism).

In practice, because of the relatively high picture scanning frequency (refresh frequency), the position of the small area aimed on the screen may be considered substantially constant for a time interval corresponding to a certain number of successive picture scans.

The other essential additional circuit that need to be included in the combined remote control-pointer, is an electronic circuit supervising the access to the IR transmitter of the remote control, alternatively by the command codes produced by the encoder of the keyboard and by the signals pertaining to the pointer system of the invention produced by the amplifier block.

The access management electronics enables access to the transmission channel by the signals produced by the receiver in the visible spectrum if none of the keys of the remote control keyboard is pressed. When a key is pressed, the access to the communication channel is automatically attributed to the commands of the remote control keyboard for a preestablished time necessary for the transmission of the relative code to the IR receiver in the monitor or TV set and then returns to be at the disposal of the receiver of signals in the visible spectrum of the remote control-pointer for a fixed minimum uninterrupted period of time, after which, if the same key is still pressed or another key is pressed, the access is again conceded to the keyboard signals for a new preeestablished time interval sufficient to retransmit or transmit the relative code.

By keeping a key pressed for a sufficiently long time, an alternate transmission is effected. For a certain limited period of time is the code relative to the keyboard key to be transmitted, and in the successive period are the signals produced by the receiver in the visible spectrum to be transmitted, and so forth.

During command code transmission, the cursor position on the screen is kept unchanged.

A discriminating electronic circuitry, contained in the TV, provides to separate the signals pertaining to the pointer function from the signals pertaining to the commands of the remote control keys. The separation of the two types of signals may be made extremely easy by using two sufficiently different carrier frequencies for transmitting the two types of pulse signals.

Preferably, the demodulation of the two signals is done digitally and the two demodulated signals are adequately regenerated into logic signals.

While the remote control signals, by way of a software managing the remote control keys, are directly processed by a microprocessor of the TV or monitor which, in the illustrated example may also provide for an OSD function, the signals for displaying the pointer figure (cursor) on the screen are processed by the microprocessor according to a dedicated software which, using the OSD functions, generates the picture of a pointing object or cursor in the point identified by the coordinates of the center of the aimed area, read from a register which is periodically updated, every certain number of picture scanning periods.

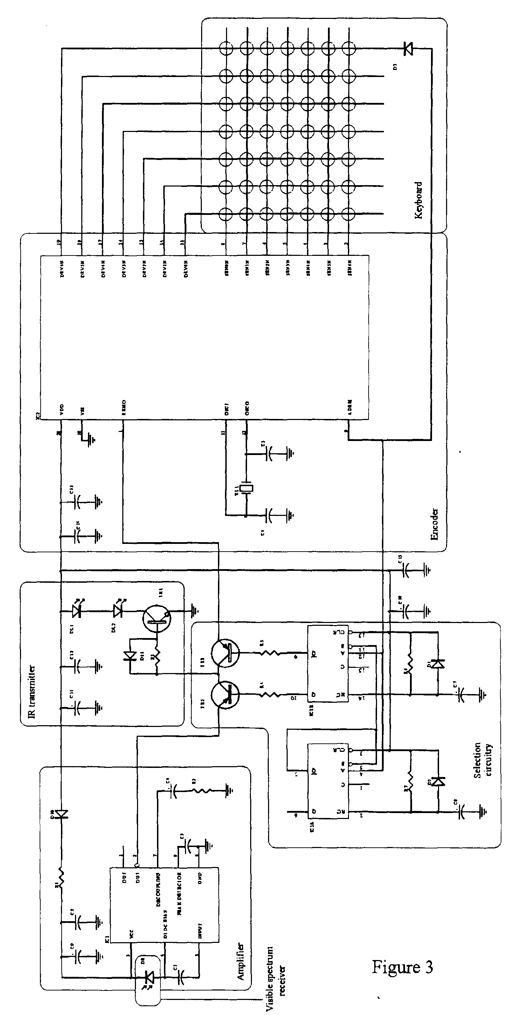

Fig. 3 shows a practical embodiment of a combined remote control-pointer device according to the present invention, using commercially available general purpose ICs or even specifically designed to realize remote controls, as is the case with the M3004 keyboard management IC.

The M3004 device is an integrated IR transmitter purposely designed to make IR remote controls for TV receivers. As shown in its data sheet, it comprises 448 commands divided in seven groups or subsystems, each of 64 commands, the subsystem or group code may be selected by pressing a key of the keyboard, acting on a slide switch or may be permanently activated.

The M3004 device generates a drive pattern of the output stage. The patterns are coded in base of the temporal distance between the pulses fronts. To the pulses may correspond flashes of infrared light or an on-off modulation of a continuous IR beam.

The transmission mode is defined together with the group address. Pulse modulation permits the use of an IR receiver in the TV with narrow band preamplifiers for enhanced noise rejection. By contrast, a flash mode requires wide band preamplifiers in the receiver.

The amplifier of the signals produced by the photodiode sensor of visible radiation associated to the focusing and aperture limiting optics may be a common IC such as a commercially available TDA 8160 device, incorporating a photodiode sensor directly coupled with the integrated circuit, a peak detection stage and an output stage of regeneration of the output pulses.

The electronic circuit for controlling the access to the IR transmitter by the signals originating from the amplifier of the visible spectrum photodetector and the signals originating from the keyboard commands may be realized using two identical commercial devices such as the M74HC4538, each consisting of a dual monostable multivibrator, realized with high-speed CMOS technology, by which two high speed switches realized by two bipolar junction transistors are controlled. The IR transmitter circuit may also be any of the commonly used ones.

Fig. 5 shows the specific diagram of the hardware that is introduced downstream of a common IR receiver of signals from a remote control existing in a TV set in order to implement the functions of the present invention.

In practice, to an existing demodulator of the carrier of the signals or codes pertaining to the management of the remote control commands (KEY CARRIER DEMODULATOR), is added a demodulator of the carrier of pointer signals (POINTER CARRIER DEMODULATOR). The latter may be realized using a timer, a latch, a comparator of the data with a preset minimum value and with a preset maximum value and to a counter. The output signal of the counter is fed to a mixer together with for example a vertical synchronism signal (of the CRT) derived from the TV circuitry.

The demodulated pulses, originating from the IR receiver, reset the timer after storing its content in the latch. The latch content is compared with the two values VALmin and VALmax and depending on the result of this comparison, the comparator sends a count increment signal or a reset signal to the counter. The counter feeds a signal to the mixer after having received a certain number of count increment signals from the comparator.

The mixer combines the content of the counter with the synchronism signal coming from the TV circuitry and sends the result to the microprocessor.

The information carried by the signals output toward the microprocessor is contained in the interval separation among the switching fronts.

In the microprocessor operates an OSD software which manages the visualization of different sets of menus and controls all The TV functions, by interfacing with the input signal through an interrupt routine in order to decode the command key signals and through another interrupt routine to manage the cursor.

In particular, the key commands management routine measures (by a hardware timer) the time elapsing between two fronts of the same type, decides whether the bit admitted is a 0 or a 1 and, once the correct number of pulses is received, communicates to the main processor that a key has been pressed, associated to a certain code and, eventually, even if the key is the same of the preceding execution of the same routing.

The cursor management routine measures the time elapsing (using a hardware timer) between the rising front and the descending front and, by performing simple sum and division operations determines the coordinates (x, y) of the geometric center of the screen area "seen" by the visual spectrum, photodetector of the remote control-pointer device aimed towards the screen, communicating this information to the main processor.

An example of this routine is shown in the flow chart of Fig. 6.

Of course, more sophisticated routines may be implemented, in order to enhance the precision of the calculation of the geometric center of the aimed area.

The outstanding ease of use of the pointer system of the invention, besides greatly facilitating the interactivity of a TV watcher with an entertaining program or information program and/or the remote control of all the presently available and also future updatable functions of the various video apparatuses, may permit even more sophisticated forms of interactivity.

For example, with the system of the invention, it is possible to implement an ordering system in a restaurant or generic service premise without attendants. By aiming a remote pointer device placed on the tables, a customer may point with an identifiable cursor an item on the menu selectable among those displayed on a distant monitor and place his order that will be automatically cued.

For this type and also for other similar applications, the pointer device of the invention may preferably actuate a combination with the signals transmitted by the pointer and/or with the commands transmitted toward the IR receiver of the monitor of a personal identification or location code. This possible embodiment is schematically indicated in the diagram of Fig. 2 by way of the phantom line block PERSONAL CODE ENCODER.

## Claims

1. A wireless pointer system to move a cursor on the screen of a video apparatus composed of
a hand brandishable remote control and pointer device comprising a photoelectric sensor sensible to visible radiation and equipped with a focusing and aperture limiting optics detecting radiation originating from an optically aimed area of said screen;
an amplifying circuit of the signal generated by said photoelectric sensor, a peak detecting circuit sensing sequences of peaks corresponding to the sequential activation of pixels of said area of the screen at the line scanning frequency of the screen, circuits of signal regeneration and of modulation of a carrier of a transmission channel from said remote device to a receiver of said apparatus;
means in said apparatus demodulating and decoding the pulses received and processing said sequences for determining coordinates on said screen of the aimed area originating the radiation detected by said photoelectric sensor;
means in said apparatus generating a picture of a pointing object or cursor on the screen at the point identified by said coordinates;
means in said hand brandishable remote control and pointer device for generating a command code and transmitting of said code to said receiver in said apparatus on said transmission channel and executing a certain function selected by pointing with said cursor a certain coded area of a selection menu shown on the screen.

2. The system according to claim 1 apparatus, characterized in that said remote control and pointer device associates the functionalities of the pointer system to those of a common OSD of remote control using in a mutually exclusive manner the same transmitter and receiver means used by a common OSD remote control.

3. The system according to claim 2, wherein the displaying on the screen of said selection menu by sending a certain code by way of said remote control, assigns the access to said transmission means to signals produced by said photoelectric sensor of the pointer system until a key of the remote control is pressed after which the position of the cursor is retained unchanged for a preestablished period of time sufficient to transmit the relative command code.

4. The system according to claim 1, characterized in that said processing means comprise logic filtering means of the data of said coordinates, verifying a substantial repeatability of the series of patterns of said pulse sequences for a temporal period corresponding to a prefixed number of scanning periods of the whole screen.

5. The system according to claim 1, characterized in that said command code contains identification data of the person keying the command.

6. A method of pointing coded areas of a selection menu displayed on the screen of a video apparatus by generating the image of a pointing object or cursor freely transferable by aiming an optical system contained in a hand brandishable aimed remote control and pointer device toward a relatively small area of the screen, that comprises sensing luminance peaks at the line scanning frequency of said screen coinciding with the sequential activation of pixels in said aimed to screen area, regenerating digital pulses and modulating the carrier of a transmission channel from said remote device to a receiver of the video apparatus;
demodulating and decoding the pulses received at the receiver and processing the received pulse sequences with a vertical synchronism signal determining the coordinates of the geometric center of the area aimed to that originates the radiation detected through the optics of the remote device and recording current coordinate values on a register;
generating the image of a pointing object or cursor on a screen at a point identified by said coordinates;
periodically updating the value of said coordinates contained in said register at intervals multiple of the period of said synchronism signal.

7. The method according to claim 6, characterized in that comprises filtering spurious events from the data relative to said coordinates by verifying pattern repeatability of said sequence of pulses at line scanning frequency over said time intervals.

8. The method according to claim 6, characterized in that comprises associating to a command code sent through said remote control and pointer device an identifying code of the person sending the command code.
